Europäisches Patentamt

European Patent Office

Office européen des brevets

(11) Veröffentlichungsnummer: **0 518 187 A2**

# EUROPÄISCHE PATENTANMELDUNG

(21) Anmeldenummer: **92109306.8**

(51) Int. Cl.5: **H01L 39/24**

(22) Anmeldetag: **02.06.92**

(30) Priorität: **14.06.91 DE 4119707**

(43) Veröffentlichungstag der Anmeldung:
**16.12.92 Patentblatt 92/51**

(84) Benannte Vertragsstaaten:
**CH DE FR GB IT LI NL**

(71) Anmelder: **SIEMENS AKTIENGESELLSCHAFT**
**Wittelsbacherplatz 2**
**W-8000 München 2(DE)**

(72) Erfinder: **Hofer, Gerhard, Dr.**
**Hauptstrasse 1**
**W-8551 Röttenbach(DE)**
Erfinder: **Kleinlein, Wilhelm, Dr.**
**Bahnhofsplatz 8**
**W-8510 Fürth(DE)**
Erfinder: **Hoenig, Eckhardt, Dr.**
**Palmstrasse 1a**
**W-8520 Erlangen(DE)**

(54) Verfahren zum Herstellen eines hochtemperatur-supraleitenden Bauteiles und hochtemperatur-supraleitendes Bauteil.

(57) Die Erfindung betrifft ein Verfahren zum Herstellen eines hochtemperatur-supraleitenden Bauteiles. Dabei wird auf einen Träger eine Schicht aus einem einen Hochtemperatur-Supraleiter bildenden Oxid aufgebracht. Die Schicht wird dann in eine hochtemperatur-supraleitende Keramik umgewandelt. Die Erfindung betrifft auch ein solches Bauteil. Es ist vorgesehen, daß auf den Träger das Oxid vortexturiert aufgebracht wird, daß die Schicht schnell aufgeschmolzen und schnell wieder abgekühlt wird und daß die Schicht dann zur Rückreaktion und gerichteten Rekristallisation geglüht wird. Das Hochtemperatur-supraleitende Bauteil gemäß der Erfindung zeichnet sich dadurch aus, daß es $YBa_2Cu_3O_{6,5+x}$ enthält und kein $Y_2BaCuO_5$, das zur Mikrorißbildung führen würde.

Die Erfindung betrifft ein Verfahren zum Herstellen eines texturierten hochtemperatur-supraleitenden Bauteiles, wobei auf einen Träger eine Schicht aus einem einen Hochtemperatur-Supraleiter bildenden Oxid mit der Formel $YBa_2Cu_3O_{6,5+x}$ aufgebracht wird, die dann in eine hochtemperatur-supraleitende Keramik umgewandelt wird.

Die Erfindung betrifft auch ein hochtemperatur-supraleitendes Bauteil, mit einem Träger, der eine Schicht aus einer hochtemperatur-supraleitenden Keramik trägt.

Diese supraleitende Keramik ist, wenn sie eine möglichst hohe Stromtragfähigkeit besitzt, dicht und texturiert. Die Texturierung der Keramik bedeutet, daß die einzelnen Kristallite kristallographisch ausgerichtet sind, wobei die Ausrichtung durch die orthorhombische c-Achse bestimmt ist. Bei einer hohen Stromtragfähigkeit steht die c-Achse senkrecht zur Stromrichtung.

Bei kongruent schmelzendem Material erfolgt bekanntermaßen (z.B. gemäß W. Kurz, P.R. Sahm, "Gerichtet erstarrte eutektische Werkstoffe, Herstellung, Eigenschaften und Anwendungen von In-Situ-Verbundwerkstoffen", Springer Verlag Berlin 1975) das Texturieren durch langsames Erstarren der Schmelze, wobei ein steiler Temperaturgradient senkrecht zur Grenzfläche Schmelze/Festkörper aufrechterhalten wird. Die Richtung der größten Kornwachstumsgeschwindigkeit fällt dabei mit der Richtung des Temperaturgradienten zusammen.

$YBa_2Cu_3O_{6,5+x}$, im folgenden auch mit "123" bezeichnet, erfüllt nicht die Voraussetzung des kongruenten Schmelzens bei langsamer, quasiisothermer Prozeßführung. Statt dessen erfolgt bei der ersten peritektischen Temperatur ein Teilschmelzen gemäß der Reaktion

$$YBa_2Cu_3O_{6,5+x} \rightarrow Y_2BaCuO_5 + \text{Schmelze (L1)}.$$

Die dabei entstehende sogenannte "Grüne Phase" $Y_2BaCuO_5$, im folgenden auch mit "211" bezeichnet, reagiert nur sehr langsam beim Erstarren wieder zur Ausgangsphase "123" zurück. In der Regel bleiben, wie eigene Untersuchungen gezeigt haben, "211"-Körner im Gefüge der erstarrten Keramik übrig, die in der "123"-Matrix zur Rißbildung und damit zu einer Begrenzung der Stromtragfähigkeit führen können.

Aus einem Vortrag von Nagaja et al, (Titel: "Rapid Solidification of High-$T_c$ Oxide Superconductor by a Laser Melting Method", vorgetragen bei der "1990 Applied Superconductivity Conference", Snowmass Village, Colorado, Sept. 24-28, 1990) ist zu entnehmen, daß bei schnellem Erhitzen und Abkühlen von "123" neben der Schmelze $Y_2O_3$ gebildet, die "Grüne Phase" also unterdrückt wird.

Der Erfindung liegt die Aufgabe zugrunde, ein Verfahren zum Herstellen eines hochtemperatur-supraleitenden Bauteils anzugeben, das den Aufbau einer stabilen, von Rissen freien und texturierten Schicht gewährleistet. Außerdem soll ein solches Bauteil angegeben werden.

Die erstgenannte Aufgabe wird gemäß der Erfindung dadurch gelöst, daß auf den Träger das Oxid vortexturiert aufgebracht wird, daß die Schicht schnell aufgeschmolzen und wieder abgekühlt wird und daß die dadurch umgeschmolzene Schicht dann zur Rückreaktion und gerichteten Rekristallisation geglüht wird.

Der Träger kann aus Silber oder Nickel oder aus einem anderen hochschmelzendem Metall bestehen.

Die Rückreaktion wird durch folgende Reaktionsgleichung beschrieben:

$$Y_2O_3 + \text{erstarrte Schmelze (L}_2) \rightarrow YBa_2Cu_3O_{6,5+x}$$

Die Erfindung zeichnet sich durch folgende Erkenntnisse aus:
- Eine dichte, hochtemperatur-supraleitende Keramikschicht wird durch einen Schmelzprozeß erzielt.
- Zur Vermeidung der rißbildenden "211"-Phase ist ein schneller Umschmelzprozeß erforderlich, mit einer Temperaturänderungsgeschwindigkeit größer als 100 K/min.
- Die Texturierung wird durch eine Vortexturierung des Ausgangsoxids auf dem Träger und die gerichtete Rekristallisation bei der Rückreaktion erzielt.

Mit dem Verfahren gemäß der Erfindung wird der Vorteil erzielt, daß das hergestellte Bauteil keine Mikrorisse aufweist und, deshalb sowie wegen der eingestellten Textur eine hohe Stromtragfähigkeit besitzt.

Beispielsweise wird das Oxid auf den Träger in einem Magnetfeld mit einem Elektrophoreseverfahren aufgebracht. Damit erhält man eine Texturierung, die darauf zurückzuführen ist, daß Kristallite während des Elektrophoreseverfahrens durch das Magnetfeld ausgerichtet werden. Vorteilhafterweise kann durch die Wahl der Magnetfeldrichtung bestimmt werden, in welcher Richtung die Kristallite ausgerichtet sein sollen.

Beispielsweise kann die vortexturierte Schicht gesintert werden, um ihre Stabilität für die weitere Verarbeitung zu erhöhen.

Die vortexturiert aufgebrachte und gegebenenfalls gesinterte Schicht kann beispielsweise gezielt nicht vollständig über ihre Dicke aufgeschmolzen werden. Durch unvollständiges Aufschmelzen ist sichergestellt, daß texturiertes, ausgerichtetes Material weiter vorhanden ist. Dieses ausgerichtete Material ist der nicht aufgeschmolzene Rest. Bei der anschließenden Rückreaktion und Rekristallisation der Schmelze dient der texturierte, nicht aufgeschmolzene Rest als Kristallisationskeim und bewirkt, daß bei der Rückreaktion und Rekristallisation aus dem aufgeschmolzenen Material ein in der gewünschten Weise texturiertes Material aufwächst, ähnlich wie bei einem epitaktischen Wachstum.

Dabei wird diese gerichtete Rekristallisation durch einen beispielsweise zeitlich veränderlichen oder konstanten Temperaturgradienten unterstützt, der immer möglichst senkrecht zur kristallographischen c-Achse orientiert sein muß. Bedingt durch den Temperaturgradienten erhält man eine verbesserte Texturierung.

Die mit dem obengenannten Elektrophoreseverfahren eingestellte Vortexturierung der Kristallite und die damit verbundene günstigste Richtung des Temperaturgradienten kann wahlweise in Richtung oder senkrecht zur Richtung des späteren Stromflusses im Bauteil orientiert sein.

Soll aus einem bandförmigen Bauteil eine Spule zur Erzeugung eines Magnetfeldes geformt werden, so wird eine höhere Stromtragfähigkeit erzielt, wenn das erzeugte Magnetfeld senkrecht zur c-Achse der Kristallite liegt. Aus geometrischen Gründen muß dann die c-Achse senkrecht auf der Oberfläche des bandförmigen Bauteils stehen (in der gewickelten Spule zeigen die c-Achsen der Kristallite auf die Achse der Spule), weshalb für die Richtung des Temperaturgradienten die Richtung des späteren Stromflusses zu wählen ist.

Eine Ausrichtung des Temperaturgradienten senkrecht zur späteren Stromrichtung und senkrecht zur Oberfläche des bandförmigen Bauteils ist aber technisch einfacher auszuführen. In diesem Fall liegt die c-Achse in der Oberfläche des bandförmigen Bauteils. Ein solches Bauteil ist für den Einsatz als Hochstromleiter geeignet.

Beispielsweise wird die elektrophoretisch aufgebrachte, vortexturierte Schicht bei einer Temperatur oberhalb des Eutektikums ("123" + 3BaCuO$_2$ + CuO) und unterhalb des ersten Peritektikums ("123") im quasi-binären Gleichgewichtsphasendiagramm, gesintert. Beispielsweise ist die stöchiometrische Zusammensetzung des Ausgangspulvers eher etwas in Richtung auf das Eutektikum verschoben. Dadurch wird der Vorteil erzielt, daß im genannten Temperaturbereich außer der gewünschten Phase YBa$_2$Cu$_3$O$_{6,5+x}$, die auch als "123" bezeichnet wird, nur eine flüssige Phase stabil ist, nicht aber die sogenannte "Grüne Phase" Y$_2$BaCuO$_5$, die auch mit "211" bezeichnet wird. Die flüssige Phase fördert den Sintervorgang. Die eutektische Temperatur kann bei 900°C, die erste peritektische Temperatur kann bei 1000°C liegen.

Die Schicht wird beispielsweise bei einer Temperatur oberhalb des zweiten Peritektikums schnell aufgeschmolzen. Damit wird der Vorteil erzielt, daß in der Schmelze, neben der flüssigen Phase, nur Y$_2$O$_3$ vorhanden ist. Die Schmelze enthält bei der vorgesehenen hohen Temperatur kein "211". Durch das schnelle Aufheizen und Abkühlen wird der Temperaturbereich zwischen dem ersten und dem zweiten Peritektikum, in dem "211" stabil ist, so schnell durchlaufen, daß "211" nicht entstehen kann. Bei isothermen Bedingungen wird das erste Peritektikum bei 1000°C und das zweite Peritektikum bei 1200°C liegen.

Beispielsweise ist die Verweildauer oberhalb des zweiten Peritektikums kurz, z.B. im Sekundenbereich. Dadurch ist das nach dem Erstarren erhaltene Gefüge sehr feinkörnig. Es wird der Vorteil erzielt, daß für die Rückreaktion und gerichtete Rekristallisation ein wegen der großen Grenzfläche hochreaktives Ausgangsmaterial bereitsteht.

Unmittelbar auf das Aufschmelzen erfolgt das Abkühlen. Die Schmelze wird schnell auf beispielsweise Raumtemperatur (ca. 20°C) abgekühlt. Das schnelle Abkühlen kann mittels eines Kühlgases beschleunigt werden, die Temperaturänderungsgeschwindigkeit kann beispielsweise größer als 100 K/min sein.

Beispielsweise wird die Schicht bei einer Temperatur um das Eutektikum und unterhalb des ersten Peritektikums, z.B. in einem Ofen, geglüht. Dabei läuft die Rückreaktion

$$Y_2O_3 + L_2 \rightarrow YBa_2Cu_3O_{6,5+x}$$

und die gerichtete Rekristallisation ab. Ausgehend vom nicht geschmolzenen Rest als Kristallisationskeim wachsen "123" Körner in Richtung des Temperaturgradienten und senkrecht zu ihrer c-Achse.

Nach dieser Glühung wird langsam abgekühlt. Damit wird der Vorteil erzielt, daß Wärmespannungen klein bleiben und nicht zur Rißbildung führen.

Beispielsweise wird in einem bestimmten Temperaturbereich die Temperatur sehr langsam abgesenkt, damit sich eine orthorhombische Struktur der "123"-Phase vollständig ausbilden kann. Dieser Temperaturbereich kann beispielsweise zwischen 700°C und 400° liegen, die Temperaturänderungsgeschwindigkeit kann beispielsweise 20K/h betragen.

Die Ofenatmosphäre beim Glühen kann beispielsweise mit Sauerstoff angereichert sein. Damit wird der Vorteil erzielt, daß der optimale Sauerstoffgehalt von YBa$_2$Cu$_3$O$_{6,5+x}$, x $\cong$ 0,4, schneller erreicht wird.

Beispielsweise wird die Schicht mit einem Laser hoher Intensität aufgeschmolzen. Mit einem solchen Laser, beispielsweise einem gepulsten Nd-YAG-Laser, kann eine ausreichend große Temperaturänderungsgeschwindigkeit erzielt werden, so daß "211" nicht entstehen kann. Die Temperaturänderungsgeschwindigkeit kann beispielsweise größer als 100 K/min sein.

Falls eine Verbesserung der Stromtragfähigkeit in Gegenwart eines Magnetfeldes erforderlich werden sollte, kann die Schicht beispielsweise mit hochenergetischen Partikeln, beispielsweise Sauerstoffionen oder Jodionen bestrahlt werden, wodurch Verankerungszentren für magnetische Flußschläuche in einem Supraleiter zweiter Art erzeugt werden. Den gleichen Effekt kann man auch durch feinstverteilte Ausscheidungsteilchen in den "123"-Körnern erzielen.

Mit dem Verfahren zum Herstellen eines hochtemperatur-supraleitenden Bauteils gemäß der Erfindung wird der Vorteil erzielt, daß ein hochtemperatur-upraleitendes Bauteil hergestellt werden kann, das texturiert ist und keine Mikrorisse, die die Stromtragfähigkeit beeinträchtigen, aufweist, die auf Einschlüsse aus 211-Oxid, der sogenannten "Grünen Phase", zurückzuführen wären.

Die zweitgenannte Aufgabe, ein hochtemperatur-supraleitendes Bauteil anzugeben, mit einem Träger, der eine Schicht aus einer hochtemperatur-supraleitenden Keramik trägt, wird gemäß der Erfindung dadurch gelöst, daß die Schicht aus 123-Oxid, $YBa_2Cu_3O_{6,5+x}$, gebildet ist und kein 211-Oxid, $Y_2BaCuO_5$, enthält.

Das 211-Oxid, das auch "Grüne Phase" genannt wird, kann Mikrorißbildung bewirken.

Yttrium kann auch durch ein Element der seltenen Erdmetalle ersetzt werden.

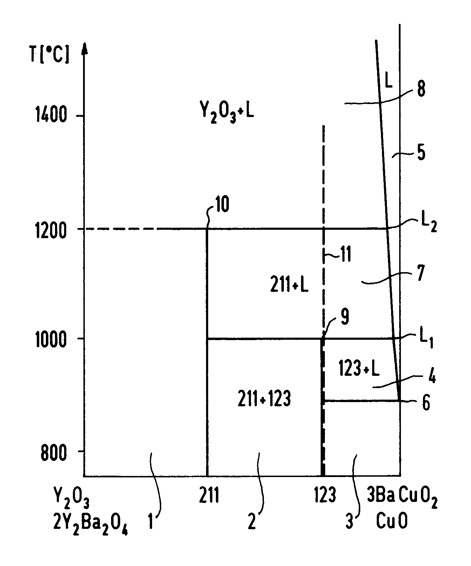

Das Verfahren gemäß der Erfindung wird anhand der Zeichnung näher erläutert:
Die Zeichnung zeigt ein quasi-binäres Gleichgewichtsphasendiagramm aus dem $\frac{1}{2}Y_2O_3$-BaO-CuO-System. Auf der Ordinate ist die Temperatur in Grad-Celsius aufgetragen. Im Feld 1 existiert das Gemenge aus $(Y_2O_3 + 2Y_2Ba_2O_4)$ und "211", wobei mit "211" das Oxid $Y_2BaCuO_5$ bezeichnet wird. Im Feld 2 existiert das Gemenge aus "211" und "123", wobei mit "123" die supraleitende Phase $YBa_2Cu_3O_{6,5+x}$ bezeichnet wird. Im Feld 3 existiert das Gemenge aus $(3BaCuO_2 + CuO)$ und "123". Längs der vertikalen Linie bei "123" auf der Abszisse ist die Phase "123" stabil. Im Feld 4 sind "123" und eine Flüssigkeit L stabil. Im Feld 5 ist nur eine Flüssigkeit L stabil. Bei der Temperatur des Eutektikums 6 ist die Ausdehnung des Feldes 5 gleich Null. Im Feld 7 sind die Phase "211" und eine Flüssigkeit L stabil. Im Feld 8 sind die Phase $Y_2O_3$ und eine Flüssigkeit L stabil.

Beim ersten Peritektikum 9 zerfällt die reine Phase "123" in "211" und eine erste Flüssigkeit $L_1$. Im zweiten Peritektikum 10 zerfällt die reine Phase "211" in $Y_2O_3$ und eine zweite Flüssigkeit L2.

Das Verfahren zum Herstellen eines hochtemperatur-supraleitenden Bauteils läuft auf der gestrichelten Linie 11 ab und geht von Feld 3, jedoch in unmittelbarer Nähe zur "123"-Phase aus. Das Ausgangspulver, das texturiert auf den Träger aufgebracht wird, enthält "123" und Spuren von $3BaCuO_2 + CuO$.

Der beispielsweise darauffolgende Sintervorgang erfolgt in Feld 4 bei einer Temperatur um das Eutektikum 6 und unterhalb des ersten Peritektikums 9.

Das schnelle Aufschmelzen erfolgt, ausgehend von Feld 3, im Feld 8, also oberhalb des zweiten Peritektikums 10. Dabei muß das Überspringen vor allem von Feld 7 beim Aufheizen und Abkühlen so schnell erfolgen, daß die zugehörige Zerfallsreaktion
"123" → "211" + L
beim Aufheizen
und die Bildungsreaktion
$Y_2O_3 + L$ → "211"
beim Abkühlen
kinetisch unterdrückt wird.

Schließlich wird gemäß dem Verfahren nach der Erfindung zur Rückreaktion und gerichteten Rekristallisation ein Glühschritt im Feld 4 bzw. im oberen Bereich von Feld 3 vorgenommen, der wie schon das Sintern, in der Nähe der Temperatur des Eutektikums 6, und unterhalb der Temperatur des ersten Peritektikums 9 erfolgt.

Dadurch ist sichergestellt, daß der fertige Hochtemperatur-Supraleiter gemäß der Erfindung ausschließlich aus dem gewünschten "123"-Oxid aufgebaut ist und kein "211"-Oxid, bzw. seine Folgeprodukte enthält, die für Mikrorisse bzw. Verunreinigungen durch Kuprate auf den Korngrenzen verantwortlich sind. Man erhält dadurch einen Hochtemperatur-Supraleiter mit hoher Stromtragfähigkeit und hoher Stabilität in Verbindung mit dem Träger.

**Patentansprüche**

1. Verfahren zum Herstellen eines texturierten hochtemperatursupraleitenden Bauteils, wobei auf einem Träger eine Schicht aus einem einen Hochtemperatur-Supraleiter bildenden Oxid aufgebracht wird, die dann in eine hochtemperatur-supraleitende Keramik umgewandelt wird,
   **dadurch gekennzeichnet,** daß auf den Träger das Oxid vortexturiert aufgebracht wird,
   daß die Schicht schnell aufgeschmolzen und schnell wieder abgekühlt wird und
   daß die dadurch umgeschmolzene Schicht dann zur Rückreaktion und gerichteten Rekristallisation geglüht wird.

2. Verfahren nach Anspruch 1,
   **dadurch gekennzeichnet,** daß auf den Träger das Oxid in einem Magnetfeld mit einem Elektrophorese-Verfahren aufgebracht wird.

3. Verfahren nach einem der Ansprüche 1 oder 2, **dadurch gekennzeichnet,** daß die texturierte Schicht gesintert wird.

4. Verfahren nach einem der Ansprüche 1 bis 3, **dadurch gekennzeichnet,** daß die Schicht über ihre Dicke nicht vollständig aufgeschmolzen wird.

5. Verfahren nach einem der Ansprüche 1 bis 4, **dadurch gekennzeichnet,** daß die Schicht bei einem zeitlich veränderlichen oder konstanten, senkrecht zur kristallographischen c-Achse orientierten Temperaturgradient texturiert wird.

6. Verfahren nach Anspruch 5, **dadurch gekennzeichnet,** daß die Schicht bei einem in Richtung des späteren Stromflusses im Bauteil orientierten Temperaturgradient texturiert wird.

7. Verfahren nach Anspruch 5, **dadurch gekennzeichnet,** daß die Schicht bei einem senkrecht zur Richtung des späteren Stromflusses im Bauteil orientierten Temperaturgradient texturiert wird.

8. Verfahren nach einem der Ansprüche 3 bis 7, **dadurch gekennzeichnet,** daß die Schicht bei einer Temperatur oberhalb der Temperatur um das Eutektikum (6) im Gleichgewichtszustand und unterhalb der Temperatur des ersten Peritektikums (9) gesintert wird.

9. Verfahren nach einem der Ansprüche 1 bis 8, **dadurch gekennzeichnet,** daß die Schicht bei einer Temperatur oberhalb des zweiten Peritektikums (10) aufgeschmolzen wird.

10. Verfahren nach Anspruch 9, **dadurch gekennzeichnet,** daß die Temperatur kurzzeitig oberhalb des zweiten Peritektikums gehalten wird.

11. Verfahren nach einem der Ansprüche 1 bis 10, **dadurch gekennzeichnet,** daß die Schicht schnell auf Raumtemperatur abgekühlt wird.

12. Verfahren nach einenm der Ansprüche 1 bis 11, **dadurch gekennzeichnet,** daß die Schicht bei einer Temperatur oberhalb der Temperatur um das Eutektikum (6) im Gleichgewichtszustand und unterhalb der Temperatur des ersten Peritektikums (9) zur Rekristallisation geglüht wird.

13. Verfahren nach einem der Ansprüche 1 bis 12, **dadurch gekennzeichnet,** daß die Schicht mit einem Laser hoher Intensität aufgeschmolzen wird.

14. Verfahren nach einem der Ansprüche 1 bis 13, **dadurch gekennzeichnet,** daß die Schicht mittels eines Kühlgases schnell wieder abgekühlt wird.

15. Verfahren nach einem der Ansprüche 1 bis 14, **dadurch gekennzeichnet,** daß die Schicht nach der Rekristallisationsglühung mit hochenergetischen, schweren Ionen bestrahlt wird.

16. Hochtemperatur-supraleitendes Bauteil, mit einem Träger, der eine Schicht aus einer hochtemperatur-supraleitenden Keramik trägt, **dadurch gekennzeichnet,** daß die Schicht aus 1-2-3-Oxid, $YBa_2Cu_3O_{6,5+x}$, gebildet ist und kein 2-1-1-Oxid, $Y_2BaCuO_5$, enthält.